# EUROPÄISCHE PATENTSCHRIFT

(11) **EP 3 874 919 B1**
(45) Veröffentlichungstag und Bekanntmachung des Hinweises auf die Patenterteilung: **04.09.2024**
(21) Anmeldenummer: 19801241.1
(22) Anmeldetag: 31.10.2019
(51) Int. Cl.: H05K 5/02, H05K 5/06, B60R 16/023, B61L 1/00, H02B 1/00, B61L 15/00, H05K 5/03

(54) **GEHÄUSE FÜR EINEN SWITCH FÜR BAHNANWENDUNGEN**
HOUSING FOR A SWITCH FOR RAILROAD APPLICATIONS
BOÎTIER POUR UN INTERRUPTEUR POUR DES APPLICATIONS FERROVIAIRES

(30) Priorität: 31.10.2018 DE 102018127249
(43) Veröffentlichungstag der Anmeldung: 08.09.2021
(73) Patentinhaber: Hirschmann Automation and Control GmbH, 72654 Neckartenzlingen (DE)
(72) Erfinder: MAYER, Sebastian, 72585 Riederich (DE); STIEGLER, Andreas, 72138 Kirchentellinsfurt (DE)
(74) Vertreter: Greif, Thomas
(86) Internationale Anmeldenummer: PCT/EP2019/079866
(87) Internationale Veröffentlichungsnummer: WO 2020/089412

(56) Entgegenhaltungen:
- DE-B3- 102010 062 837
- DE-T2- 69 912 657
- DE-T5- 112012 004 558

## Beschreibung

Die Erfindung betrifft ein Gehäuse für einen Switch für Bahnanwendungen gemäß den Merkmalen des Oberbegriffes des Patentanspruches 1.

Switche, die ein Gehäuse aufweisen, und die insbesondere in Personenwaggons von Bahnen eingebaut sind, sind bekannt. Diese dienen der Datenübertragung und gegebenenfalls auch der Energieübertragung.

Es sind Gehäuse für solche Switche bekannt, bei denen die Eingänge und Ausgänge (wie Anschlüsse für Versorgung, Management und Datenübertragung für die Kabel, mit denen die Datenübertragung erfolgt) in nur einer einzigen Ebene angeordnet sind, sodass auch die Steckverbinder am Ende der Kabel alle in einer einzigen Ebene in diese Eingänge und Ausgänge gesteckt werden. Dies führt zu einer sehr großen, das heißt zusätzlichen Vergrößerung des benötigten Bauraumes und somit zu einer hohen Bauweise des Gesamtsystems "Switch", wobei der hierfür zur Verfügung stehende Bauraum zum Beispiel in den Personenwaggons bzw. deren Böden und Decken in der Regel nicht ausreichend ist.

Ein gattungsbildendes Gehäuse ist aus der DE 10 2010 062 837 B3 bekannt.

Der Erfindung liegt daher die Aufgabe zugrunde, einen Switch für Bahnanwendungen gegenüber bekannten Switchen zu verbessern, insbesondere im Hinblick auf eine kompakte Bauweise und einen verbesserten Regelbetrieb.

Diese Aufgabe ist durch die Merkmale des Patentanspruches 1 gelöst.

Nach der Erfindung ist daher vorgesehen, dass das Gehäuse des Switches ein flach bauendes Teil aufweist und ausgehend von diesem flachbauenden Teil ein darüber hinausragendes höheres Teil sich anschließt, wobei von dem flachbauenden Teil die Eingänge und Ausgänge auf der Oberseite dieses Teiles angeordnet sind und die Kabel mit ihren Steckverbindern in etwa senkrecht in diese Eingänge und Ausgänge gesteckt werden. Die weiteren Eingänge und Ausgänge in dem höherbauenden Teil sind in etwa im rechten Winkel dazu angeordnet. Auf diese Art und Weise weist das Gehäuse des neuen Switches im Schnitt bzw. von der Seite aus betrachtet in etwa einen L-förmigen Querschnitt auf, wobei die Eingänge und Ausgänge auf dem einen Schenkel in etwa senkrecht nach oben abstehen und die Eingänge und Ausgänge in etwa im rechten Winkel dazu von dem anderen Schenkel ausgehen.

Dadurch wird erreicht, dass sämtliche Kabelführungen innerhalb der durch das Gehäuse vorgegebenen Maximalhöhe, in der Vorzugsrichtung erfolgen kann.

Ein weiterer Vorteil dieser Steckeranordnung ist, dass alle Anschlüsse in nur einem Teilbereich liegen, diese aber dennoch recht gut erreichbar sind. Dadurch ist der verbleibende Bereich frei von Leitungen und Kühlrippen können effektiver funktionieren, da die natürliche Konvektion weniger behindert wird. In diesem Bereich können dann Bauelemente mit erhöhter Verlustleistung platziert werden.

Weitere Ausgestaltungen des erfindungsgemäßen Gehäuses (beziehungsweise eines Switches mit einem solchen Gehäuse, der dazu ausgebildet und geeignet ist, in der Bahntechnik angewendet zu werden) sind in den Unteransprüchen angegeben, aus denen sich entsprechende Vorteile ergeben. Diese werden auch noch im Zusammenhang mit der folgenden Figurenbeschreibung näher erläutert, ohne dass sie auf das gezeigte und beschriebene Ausführungsbeispiel beschränkt sind.

Eine beispielhafte Form eines Gehäuses eines Switches sowie Detailausgestaltungen sind in den Figuren in mehreren Ansichten dargestellt.

Es zeigen:
- Figur 1:: verschiedene Ansichten des Switches,
- Figur 2:: eine Draufsicht auf den Switch von schräg oben,

Figuren 3 bis 7: dreidimensionale Ansichten des Switches in verschiedene Explosionsdarstellungen.

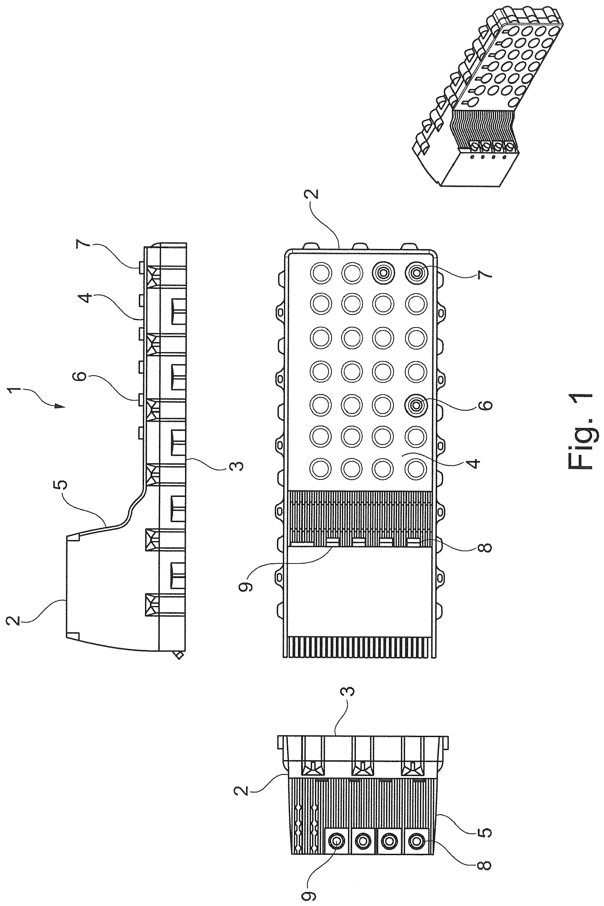

Figur 1 zeigt, soweit im Einzelnen dargestellt, verschiedene Ansichten eines Switches 1 für Bahnanwendungen. Dieser Switch 1 weist ein Gehäuse 2 auf, wobei das Gehäuse 2 eine Unterseite 3 aufweist, mit der das Gehäuse 2 beispielsweise auf einer Fläche eines Einbauortes des Switches 1 aufgelegt und gegebenenfalls befestigt wird. Etwa parallel zu der Unterseite 3 ist ein erster Schenkel 4 (flächig ausgebildet) des Gehäuses 2 vorhanden, wobei etwa senkrecht zu diesem ersten Schenkel 4 ein weiterer Schenkel 5 (ebenfalls flächig ausgebildet) angeordnet ist. Der Übergangsbereich zwischen den beiden Schenkeln 4, 5 kann scharfkantig, zum Beispiel in einem Winkel von 90°, ausgebildet sein. In dem gezeigten Ausführungsbeispiel ist der Übergangsbereich gerundet ausgeführt. Auf der Oberseite des Schenkels 4 sind zumindest ein Anschluss, vorzugsweise jedoch mehrere Anschlüsse für Steckverbinder oder dergleichen, vorhanden. Bei diesen Anschlüssen handelt es sich um zumindest einen Eingang 6, vorzugsweise mehrere Eingänge, und/oder zumindest einen Ausgang 7, vorzugsweise mehrere Ausgänge 7. Analog dazu ist auf der Oberfläche des Schenkels 5 zumindest ein Ausgang und/oder ein Eingang vorhanden. Bei diesem Ausführungsbeispiel sind zwei Eingänge 8 und zwei Ausgänge 9 vorhanden. Die Anzahl der dargestellten Eingänge 6, 8 bzw. der dargestellten Ausgänge 7, 9 ist beispielhaft und kann nach Anwendungsfall größer oder kleiner sein. Somit ist in Figur 1 dargestellt und erkennbar, dass der Switch 1 ein Gehäuse aufweist, wobei der Switch 1 für Bahnanwendungen geeignet und ausgebildet ist und das Gehäuse 2 im Schnitt bzw. von der Seite aus betrachtet in etwa einen L-förmigen Querschnitt aufweist, wobei die Eingänge 6 und Ausgänge 7 auf den einen Schenkel 4 in etwa senkrecht nach oben abstehen und die Eingänge 8 und Ausgänge 9 in etwa im parallelen Winkel dazu von dem anderen Schenkel 5 ausgehen.

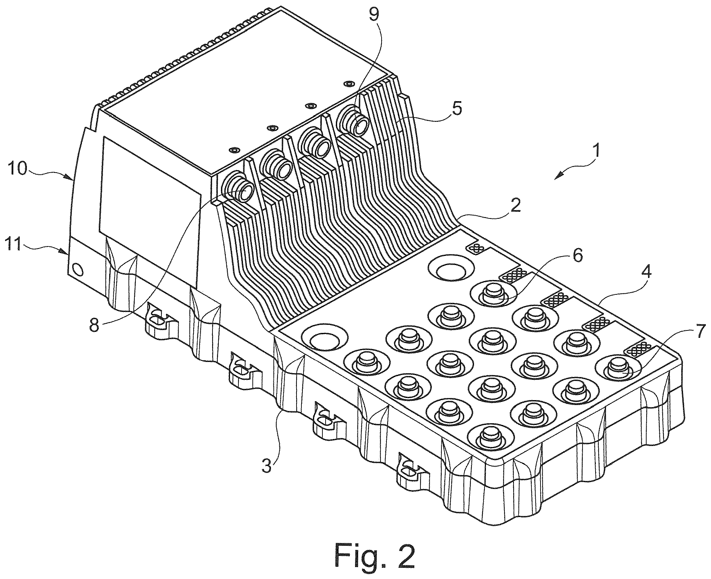

In Figur 2 ist eine Draufsicht auf den Switch 1 von schräg oben dargestellt. In dieser Ansicht ist erkennbar, dass das Gehäuse 2 zumindest zweigeteilt ist. Im Falle der Zweiteiligkeit weist das Gehäuse 2 ein Oberteil 10 und ein Unterteil 11 auf. Das Unterteil 11 ist flächig gestaltet, wobei das Oberteil 10 die beiden flächigen Bereiche, die die Schenkel 4 und 5 bilden, aufweist. Außerdem schließt sich dem nach oben abstehenden Ende des Schenkels 5 eine dachförmige Ausgestaltung des Oberteiles 10 an.

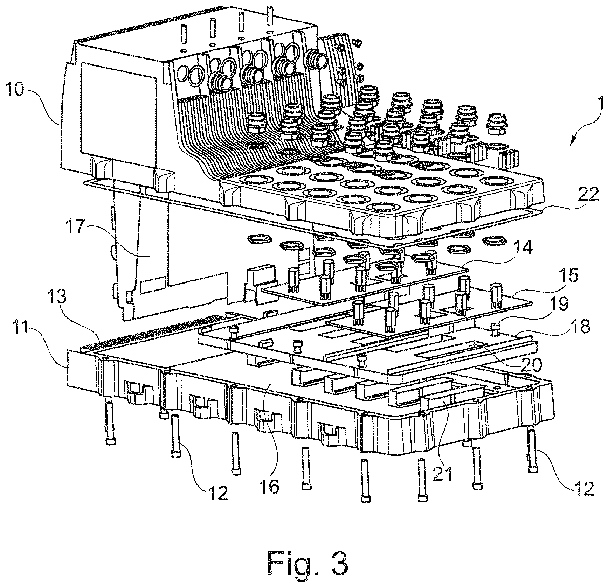

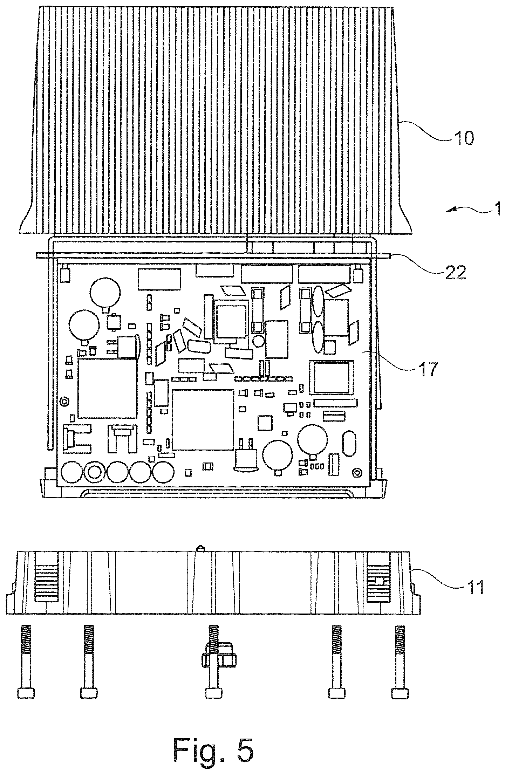

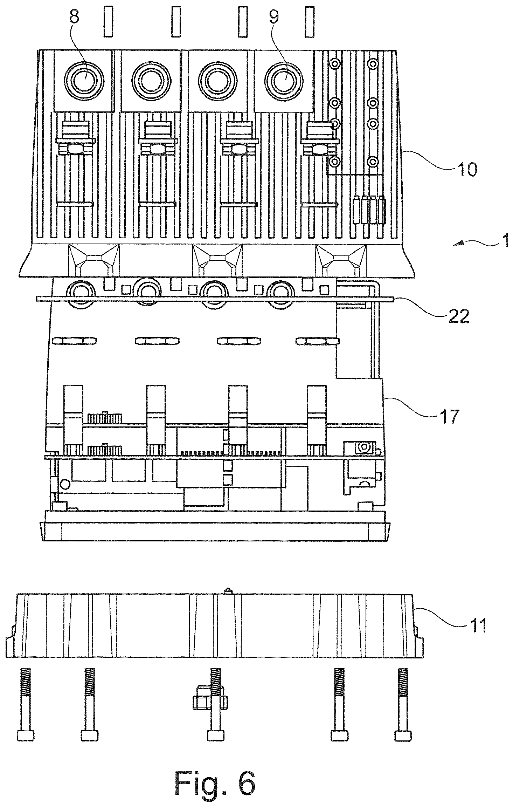

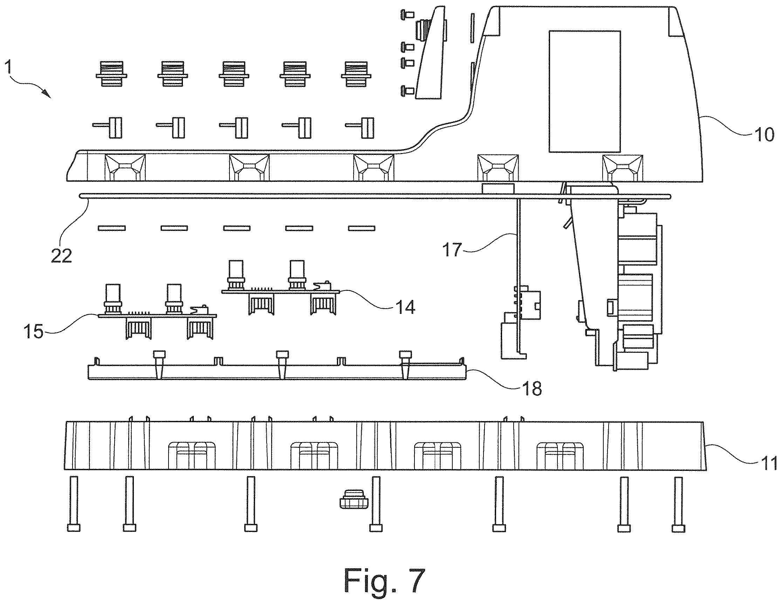

In den Figuren 3 bis 7 sind dreidimensionale Ansichten des Switches 1 in verschiedenen Explosionsdarstellungen dargestellt. Neben den Elementen des Switches 1, die schon im Zusammenhang mit den Figuren 1 und 2 beschrieben und mit gleichen Bezugsziffern versehen worden sind, wird im Folgenden auf weitere Detailausgestaltungen eingegangen.

So ist zunächst dargestellt, dass das Oberteil 10 mit Schrauben 12 an dem Unterteil 11 befestigt wird, um ein geschlossenes Gehäuse 2 zu erzeugen.

Das Oberteil 10 und/oder das Unterteil 11 weisen endseitig, insbesondere im Bereich der dachförmigen Ausgestaltung des Oberteiles 10, Kühlrippen 13 auf. Solche Kühlrippen können auch in dem Übergangsbereich, insbesondere einem bogenförmigen Übergangsbereich, von dem Schenkel 4 in Richtung des Schenkels 5 vorgesehen werden.

Innerhalb des Gehäuses 2 ist zumindest eine Leiterplatte angeordnet, wobei auf der Leiterplatte elektrische, elektromechanische sowie elektronische Bauteile zur Realisierung der Funktion des Switches 1 angeordnet sind. Die zumindest eine Leiterplatte ist mit den Eingängen und Ausgängen entsprechend verbunden, sodass Signale von außen über die Eingänge den Bauteilen zugeleitet werden können, dort verarbeitet werden und über die Ausgänge wieder abgegeben werden können.

Bei diesem Ausführungsbeispiel sind im Bereich des Schenkels 4, genauer unterhalb der Fläche dieses Schenkels 4, beispielsweise zwei Leiterplatten 14, 15 getrennt voneinander angeordnet. Die beiden Leiterplatten 14, 15 werden in etwa parallel zu der Unterseite 3 in dem Gehäuse 2 angeordnet. Gleiches gilt für eine weitere Leiterplatte 16, die parallel unterhalb der beiden Leiterplatten 14, 15 angeordnet ist. In etwa senkrecht, vorzugsweise genau senkrecht zu den Leiterplatten 14, 15, 16 ist im Bereich des weiteren Schenkels 5 eine Leiterplatte 17 vorgesehen. Auch hier kann mehr als eine Leiterplatte 17 angeordnet werden.

Um die beiden Leiterplatten 14, 15 sowohl elektrisch (hochfrequenztechnisch), mechanisch als auch gegebenenfalls thermisch von der Leiterplatte 17 zu trennen, ist innerhalb des Gehäuses 2 ein Trennelement 18 vorgesehen. Alternativ ist auch eine thermische Ankopplung der Leiterplatten zur erhöhten Wärmeverteilung bzw. Wärmeabfuhr der elektronischen Bauelemente realisierbar. In diesem Fall hat das Trennelement keine thermisch trennende, sondern eine thermisch verbindende (übertragende) Eigenschaft. Hier wird somit allgemein oder auch im Zusammenhang mit der Beschreibung des Ausführungsbeispieles der Begriff "Trennelement" für die trennende oder thermisch ankoppelnde Eigenschaft verwendet.

Das Trennelement 18 ist flächig gestaltet. Es kann aus elektrisch leitendem Material, wie zum Beispiel aus einem Stahlblech, aber auch aus nicht-elektrisch leitenden Material, wie zum Beispiel einem Kunststoff, bestehen. Zur thermischen Trennung der beiden Leiterplatten 14, 15 von der Leiterplatte 16 kann das Trennelement 18 aus einem isolierenden Werkstoff, zum Beispiel einem Kunststoff, bestehen und erstreckt sich über die gesamte Fläche der Unterseite 3 des Gehäuses 2.ist eine elektrische undloder mechanische Trennung der beiden Leiterplatten 14,15 (oder nur einer Leiterplatte oder mehr als 2 Leiterplatten) von der Leiterplatte 17 beabsichtigt, besteht das Trennelement 18 aus einem elektrisch leitenden Werkstoff. Dadurch können insbesondere die Bauteile auf den Leiterplatten 14, 15 vor Störeinstrahlungen von den Bauteilen auf der Leiterplatte 16 abgeschirmt werden (oder umgekehrt). Das Trennelement 18 wird mit zumindest einer Schraube 19, vorzugsweise mehreren Schrauben, an dem Gehäuse 2, zum Beispiel wie in Figur 3 dargestellt an dem Unterteil 11 des Gehäuses 2, befestigt. Zwecks Durchführung weist das Trennelement 18 zumindest eine Ausnehmung 20, vorzugsweise mehrere Ausnehmungen 20, auf. Über diese zumindest eine Ausnehmung 20 kann zum Beispiel ein Steckverbinder 21, der auf der Leiterplatte 16 angeordnet ist, durch das Trennelement 18 durchgeführt und mit einem entsprechenden Gegensteckverbinder auf der Leiterplatte 14 bzw. 15 verbunden werden. Um das Innere des Gehäuse 2 vor äußeren Einwirkungen zu schützen ist zwischen den umlaufenden freien Kanten des Oberteiles 10 und des Unterteiles 11 eine Dichtung 22 einlegbar.

Die vorstehenden Ausführungen bezüglich der Leiterplatten und gegebenenfalls des Trennelementes, die in dem Bereich des Schenkels 4 angeordnet sind, gelten analog auch für die zumindest eine Leiterplatte und gegebenenfalls ein weiteres Trennelement im Bereich des Schenkels 5.

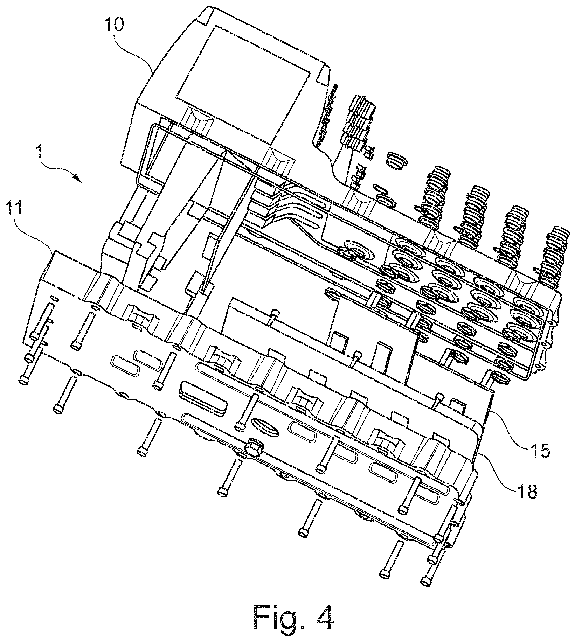

Der Explosionsdarstellung in der Figur 3, genauso wie weiteren Darstellungen der Figuren 4 bis 7, können ohne weiteres weitere Details des erfindungsgemäßen Switches 1 entnommen werden, insbesondere was die Ausgestaltung der Eingänge (Steckverbinder) und Ausgänge (Steckverbinder) betrifft.

Ebenfalls kann der Montagevorgang entnommen werden. Mit Bezug auf die Figur 3 wird beispielsweise das Unterteil 11 bereitgestellt, dort die Leiterplatte 16 eingelegt und danach das Trennelement 18 montiert. Danach wird die zumindest eine Leiterplatte 14, wie dargestellt die beiden Leiterplatten 14,1 5, auf dem Trennelement 18 angeordnet und auf geeignete Weise befestigt. Gleiches gilt für die Leiterplatte 17 und ein optional dort ebenfalls vorgesehenes Trennelement. Danach wird das Oberteil 10 des Gehäuses 2 auf das Unterteil 11, unter Zwischenbelegung der Dichtung 22, aufgesetzt, wobei die auf den Leiterplatten 14, 15 angeordneten Steckverbinder durch entsprechende Ausnehmungen in dem Schenkel 4 durchgeführt werden. Anschließend werden auf die dann abstehenden Steckverbinder Verschraubungen angebracht, genauso wie es auch für die Elemente und deren Montage im Bereich des Schenkels 5 gilt. Danach werden das Oberteil 10 und das Unterteil 11 mittels der Schrauben 12 endgültig miteinander verbunden, sodass der Switch 1 einsatzbereit ist.

### Bezugszeichenliste

- 1.: Switch
- 2.: Gehäuse
- 3.: Unterseite
- 4.: Schenkel
- 5.: Schenkel
- 6.: Eingang
- 7.: Ausgang
- 8.: Eingang
- 9.: Ausgang
- 10.: Oberteil
- 11.: Unterteil
- 12.: Schrauben
- 13.: Kühlrippen
- 14.: Leiterplatte
- 15.: Leiterplatte
- 16.: Leiterplatte
- 17.: Leiterplatte
- 18.: Trennelement
- 19.: Schraube
- 20.: Ausnehmung
- 21.: Steckverbinder
- 22.: Dichtung

## Patentansprüche

1. Gehäuse (2) eines Switches (1), ausgebildet für Datenübertragung für Bahnanwendungen, welches im Schnitt bzw. von der Seite aus betrachtet in etwa einen L-förmigen Querschnitt aufweist, wobei elektrisch mit zumindest einer Leiterplatte (14, 15) verbundene Eingänge (6) und Ausgänge (7) auf einem Schenkel (4) in etwa senkrecht nach oben abstehen und weitere elektrisch mit zumindest einer weiteren Leiterplatte (17) verbundene Eingänge (8) und Ausgänge (9) in etwa im rechten Winkel dazu von einem anderen Schenkel (5) ausgehen, **dadurch gekennzeichnet, dass** in dem Gehäuse (2) oberhalb und/oder unterhalb eines Trennelementes (18) im Bereich des Schenkels (4) die zumindest eine Leiterplatte (14, 15, 16) sowie etwa senkrecht zu einer Unterseite (3) des Gehäuses (2) im Bereich des anderen Schenkels (5) die zumindest weitere Leiterplatte (17) angeordnet ist.

2. Gehäuse (2) nach Anspruch 1, **dadurch gekennzeichnet, dass** das Gehäuse (2) gebildet ist von einem Oberteil (10) und einem Unterteil (11), wobei zwischen dem Oberteil (10) und dem Unterteil (11) eine Dichtung (22) und in dem Inneren des Gehäuses (2) das Trennelement (18) angeordnet ist, wobei das Trennelement (18) als ein von dem Oberteil (10) und dem Unterteil (11) separates Bauteil ausgebildet ist.

3. Gehäuse (2) nach Anspruch 2, **dadurch gekennzeichnet, dass** das Trennelement (18) zumindest eine Ausnehmung (20) aufweist.

4. Gehäuse (2) nach Anspruch 1, 2 oder 3, **dadurch gekennzeichnet, dass** das Oberteil (10) und/oder das Unterteil (11) an zumindest einer Endseite Kühlrippen (13) aufweist.

## Claims

1. Housing (2) for a switch (1), designed for data transmission for railway applications, which has approximately an L-shaped cross section, as viewed in section or from the side, wherein inputs (6) and outputs (7), which are electrically connected to at least one printed circuit board (14, 15), on one limb (4) protrude approximately vertically upwards, and further inputs (8) and outputs (9), which are electrically connected to at least one further printed circuit board (17), emerge approximately at right angles thereto from another limb (5), **characterized in that** the at least one printed circuit board (14, 15, 16) is arranged in the housing (2) in the region of the limb (4) above and/or below a separating element (18), and the at least one further printed circuit board (17) is arranged approximately vertically to an underside (3) of the housing (2) in the region of the other limb (5).

2. Housing (2) according to Claim 1, **characterized in that** the housing (2) is formed by an upper part (10) and a lower part (11), wherein a seal (22) is arranged between the upper part (10) and the lower part (11) and the separating element (18) is arranged in the interior of the housing (2), wherein the separating element (18) is designed as a component which is separate from the upper part (10) and the lower part (11).

3. Housing (2) according to Claim 2, **characterized in that** the separating element (18) has at least one recess (20) .

4. Housing (2) according to Claim 1, 2 or 3, **characterized in that** the upper part (10) and/or the lower part (11) has cooling fins (13) on at least one end side.

## Revendications

1. Boîtier (2) pour un commutateur (1), conçu pour la transmission de données pour des applications ferroviaires, qui, en coupe ou vu de côté, présente une section transversale sensiblement en forme de L, des entrées (6) et des sorties (7) reliées électriquement à au moins une carte à circuit imprimé (14, 15) dépassant sensiblement verticalement vers le haut sur une branche (4) et d'autres entrées (8) et sorties (9) reliées électriquement à au moins une autre carte à circuit imprimé (17) s'étendant sensiblement à angle droit depuis une autre branche (5), **caractérisé en ce que** dans le boîtier (2), au-dessus et/ou au-dessous d'un élément de séparation (18), dans la zone de la branche (4), est disposée ladite au moins une carte à circuit imprimé (14, 15, 16) ainsi que, sensiblement perpendiculairement à une face inférieure (3) du boîtier (2), dans la zone de l'autre branche (5), ladite au moins autre carte à circuit imprimé (17).

2. Boîtier (2) selon la revendication 1, **caractérisé en ce que** le boîtier (2) est formé par une partie supérieure (10) et une partie inférieure (11), un joint d'étanchéité (22) étant disposé entre la partie supérieure (10) et la partie inférieure (11) et l'élément de séparation (18) étant disposé à l'intérieur du boîtier (2), l'élément de séparation (18) étant conçu sous la forme d'un composant séparé de la partie supérieure (10) et de la partie inférieure (11).

3. Boîtier (2) selon la revendication 2, **caractérisé en ce que** l'élément de séparation (18) présente au moins un évidement (20).

4. Boîtier (2) selon la revendication 1, 2 ou 3, **caractérisé en ce que** la partie supérieure (10) et/ou la partie inférieure (11) présente des ailettes de refroidissement (13) sur au moins un côté d'extrémité.
